# EUROPÄISCHE PATENTSCHRIFT

(11) **EP 0 427 328 B1**
(45) Veröffentlichungstag und Bekanntmachung des Hinweises auf die Patenterteilung: **07.02.1996**
(21) Anmeldenummer: 90202902.4
(22) Anmeldetag: 02.11.1990
(51) Int. Cl.: H01L 21/66, G01R 31/28

(54) **Verfahren zum Herstellen von integrierten Schaltungen sowie integrierte Schaltung**
Method of manufacturing integrated circuits as well as integrated circuit
Procédé de fabrication de circuits intégrés ainsi que circuit intégré

(30) Priorität: 08.11.1989 DE 3937187
(43) Veröffentlichungstag der Anmeldung: 15.05.1991
(73) Patentinhaber: Philips Patentverwaltung GmbH, D-22335 Hamburg (DE); Philips Electronics N.V., NL-5621 BA Eindhoven (NL)
(72) Erfinder: Axer, Klaus, Dr., W-2400 Lübeck (DE)
(74) Vertreter: Poddig, Dieter, Dipl.-Ing.

(56) Entgegenhaltungen:
- PATENT ABSTRACTS OF JAPAN vol. 13, no. 251 (E-771)12. Juni 1989 & JP-A-1 051 630
- PATENT ABSTRACTS OF JAPAN vol. 11, no. 004 (E-468)7. Januar 1987 & JP-A-61 181 139
- PATENT ABSTRACTS OF JAPAN vol. 9, no. 266 (E-352)23. Oktober 1985 & JP-A-60 111 435

## Beschreibung

Die Erfindung betrifft ein Verfahren zum Herstellen von integrierten Schaltungen, bei dem eine Anzahl gleichartiger Schaltungen auf einer Halbleiterscheibe gemeinsam erzeugt und danach durch Schnitte voneinander getrennt wird, wobei jede Schaltung am Rand mit mehreren Anschlußflächen versehen wird, von denen ausschließlich für das Testen der Schaltung vor dem Trennen von den benachbarten Schaltungen verwendet werden, wobei zwischen jeweils mindestens zwei benachbarten Schaltungen an den einander zugewandten Seiten nur für das Testen verwendete Anschlußflächen vorgesehen werden.

Ferner betrifft die Erfindung eine Halbleiterscheibe mit einer Anzahl gleichartiger Schaltungen, wobei jede Schaltung am Rand mit mehreren Anschlußflächen versehen ist, von denen einige ausschließlich für das Testen der Schaltung vor dem Trennen von den benachbarten Schaltungen dienen, und die an mindestens einer Seite der Schaltung angeordnet sind.

Die Herstellung jeweils einer größeren Anzahl integrierter Schaltungen gemeinsam auf einer Halbleiterscheibe mittels Diffusions- und Ätzverfahren unter Verwendung insbesondere fotolithografischer Mittel ist allgemein bekannt. Wenn diese Herstellungsschritte alle durchgeführt sind, wird jede einzelne Schaltung auf der Halbleiterscheibe auf Funktionsfähigkeit geprüft, indem an einer Vorrichtung befestigte Meßspitzen auf die Anschlußflächen jeweils einer Schaltung aufgesetzt und darüber eine Betriebsspannung und Meßsignale zugeführt und Ausgangssignale abgeführt werden. Nicht funktionsfähige Schaltungen werden nach jedem Meßschritt markiert, so daß sie die weiteren Herstellungsschritte, insbesondere das Einbauen in ein Gehäuse und das Anschließen der Anschlußflächen über Drähte an nach außen führende Anschlüsse, nicht mehr durchlaufen.

Insbesondere digitale Schaltungen können zunächst nur durch die im normalen Betrieb verwendeten Anschlüsse getestet werden, jedoch ist ein solcher Test z.B. bei sehr komplexen Schaltungen oder auch bei Schaltungen mit sehr wenigen äußeren Anschlüssen, wie beispielsweise für kontaktlose Chipkarten verwendete Schaltungen, sehr aufwendig. Er läßt sich wesentlich vereinfachen, wenn zusätzliche Anschlüsse nur für das Testen angebracht werden, über die zusätzliche Testsignale in die Schaltung eingespeist oder Ergebnissignale nach außen herausgeführt werden, die für den normalen Betrieb nicht verwendet werden. Da Anschlußflächen jedoch insgesamt im Verhältnis zu den Elementen der eigentlichen Schaltung relativ groß sind und dies dann auch für die Anschlußflächen für das Testen gilt, wird auf diese Weise ein wesentlicher Teil der Halbleiterscheibe für derartige Anschlußflächen verbraucht, so daß weniger Schaltungen auf einer Halbleiterscheibe vorgegebener Größe erzeugt werden können und die Herstellungskosten der einzelnen Schaltung steigen.

Aus den Patent Abstracts of Japan, Band 13, Nr. 251, (E-771) 12. Juni 1989 (JP-A-1 051 630) ist ein Halbleiter 11 mit einer Anzahl gleichartiger Schaltungen bekannt, wobei jede Schaltung am Rand mit mehreren Anschlußflächen versehen ist, von denen einige ausschließlich für das Testen der Schaltung vor dem Trennen von den benachbarten Schaltungen dienen und an mindestens einer Seite der Schaltung angeordnet sind, wobei die Anschlüsse außerdem längs einer Linie, die zum späteren Trennen der Schaltungen dient, angeordnet sind.

Aufgabe der Erfindung ist es, ein Verfahren der eingangs genannten Art anzugeben, durch das die für die Anschlußflächen benötigte Gesamtfläche auf der Halbleiterscheibe möglichst gering gehalten wird.

Diese Aufgabe wird erfindungsgemäß dadurch gelöst, daß diese nur für das Testen verwendeten Anschlußflächen zumindest zum Teil diesen benachbarten Schaltungen gemeinsam sind und mit ihnen verbunden sind, und daß der Schnitt zum Trennen der einzelnen Schaltungen im wesentlichen längs einer Trennlinie durch diese Anschlußflächen gelegt wird.

Ferner besteht eine Aufgabe der Erfindung darin, eine integrierte Schaltung anzugeben, bei der die Halbleiterfläche möglichst weitgehend für die Schaltung selbst ausnutzbar und möglichst wenig Halbleiterfläche für die Anschlußflächen erforderlich ist.

Diese Aufgabe wird erfindungsgemäß dadurch gelöst, daß die nur für das Testen dienenden Anschlußflächen mit einer anderen an dieser Seite benachbarten Schaltung gemeinsam und mit dieser ebenfalls verbunden sind, und auf einer Trennlinie angeordnet sind.

Die Erfindung benutzt in vorteilhafter Weise die Tatsache, daß Anschlüsse einer Schaltung, die nicht an Betriebsspannung liegt, von dieser Schaltung praktisch nicht beeinflußt werden. Dadurch können diese Anschlüsse doppelt benutzt werden, nämlich für zwei Schaltungen, von denen jeweils eine mit Betriebsspannung versorgt wird. Dadurch können diese Schaltungen nacheinander über dieselben Anschlußflächen mit Testsignalen versorgt werden bzw. in der Schaltung erzeugte Signale darüber abgenommen werden. Nach dem Testen der Schaltungen sind diese Anschlüsse nicht mehr erforderlich und können daher zerstört werden, nämlich durch den Trennschnitt zum Trennen der Schaltungen voneinander. Dadurch wird bei jeder Reihe von derartigen doppelt zum Testen ausgenutzten Anschlußflächen der Platz für eine Reihe von Anschlußflächen sowie für den Abstand der Anschlußflächen vom Rand bzw. von der Schnittlinie gespart, so daß die gesamte Halbleiterscheibe günstiger ausgenutzt werden kann, indem mehr Schaltungen einer gegebenen Größe auf eine Halbleiterscheibe gegebener Größe untergebracht werden können.

Da auf einer Halbleiterscheibe stets gleichartige bzw. gleiche Schaltungen hergestellt werden, entsteht bei beispielsweise paarweise mit gemeinsamen Testanschlußflächen versehenen Schaltungen eine Unsymmetrie, da diese Testanschlußflächen bei der einen Schaltung beispielsweise auf der rechten und bei der anderen Schaltung auf der linken Seite angeordnet sind. Um vorzugsweise für alle Schaltungen den gleichen Aufbau in der Fläche verwenden zu können, können diese Schaltungen paarweise um 180° gegeneinander gedreht auf der Halbleiterscheibe angeordnet werden, wobei dann die Zuordnung der Testanschlußflächen bei beiden Schaltungen unterschiedlich ist. Außerdem ergibt dies nicht immer die günstigste Platzausnutzung, insbesondere wenn die für den normalen Betrieb der Schaltung verwendeten Anschlüsse an nur einer einzigen weiteren Seite angebracht werden können. Nach einer Ausgestaltung der Erfindung ist es daher zweckmäßig, daß benachbarte Schaltungen bezüglich der Seite, an der die gemeinsamen Anschlußflächen angeordnet sind, spiegelbildlich zueinander aufgebaut sind. Dies erfordert kaum zusätzlichen Aufbau beim Entwurf des Lay-outs der Schaltung und bei der Herstellung der erforderlichen Masken.

Wenn in diesem Falle die Anschlußflächen an einer Seite der Schaltung angebracht sind, die senkrecht auf der Seite mit den gemeinsamen Testanschlußflächen steht, ist auch die Zuordnung dieser Anschlußflächen für den normalen Betrieb spiegelbildlich, während die Gehäuse, in die die Schaltungen eingebaut werden, nach außen hin eine stets gleiche Anschlußbelegung aufweisen sollen. Ferner erfolgt die Herstellung der Drahtverbindungen zwischen den Anschlußflächen und den äußeren Anschlüssen des Gehäuses allgemein mittels festprogrammierter Automaten. Um trotz des spiegelbildlichen Aufbaues daher eine von außerhalb der Schaltung gesehen einheitliche Anschlußbelegung der Anschlußflächen zu erzeugen, ist es nach einer weiteren Ausgestaltung der Erfindung zweckmäßig, daß die für den normalen Betrieb der Schaltung vorgesehenen Anschlußflächen an einer Seite, die senkrecht zur Seite mit den gemeinsamen Anschlußflächen steht, symmetrisch zur Seitenmitte angeordnet sind, wobei zueinander symmetrische Anschlußflächen miteinander elektrisch verbunden sind. Dadurch sind zwar mehr Anschlußflächen erforderlich, jedoch kosten diese doppelten Anschlußflächen bei Schaltungen mit nur weniger Anschlüssen für den Normalbetrieb wie beispielsweise für kontaktlose Chipkarten oder andere Anwendungsfälle, wo die Schaltung lediglich über eine oder zwei Spulen oder Kondensatorflächen mit der Umgebung in Verbindung steht, keine zusätzliche Fläche auf der Halbleiterscheibe, solange diese Anschlußflächen weiterhin an einer Seite der Schaltung angeordnet werden können, da die Schnitte zum Trennen der einzelnen Schaltungen stets nur gerade verlaufen können.

Wenn der Schnitt durch die Anschlußflächen verläuft, kann es sein, das Material von diesen Anschlußflächen verschmiert wird, so daß benachbarte Anschlußflächen miteinander verbunden sind. Um dieses zu berücksichtigen, ist es nach einer anderen Ausgestaltung der Erfindung zweckmäßig, daß zumindest die Anschlußflächen, die vor dem Trennen der Schaltungen zwei benachbarten Schaltungen gemeinsam sind und Eingänge darstellen, innerhalb der Schaltung bei angelegter Betriebsspannung über je ein stromleitendes Element mit einem vorgegebenen Potential, insbesondere einem Pol der Betriebsspannung, verbunden sind. Die Schaltung ist dann zweckmäßig so ausgelegt, daß dieses gemeinsame Potential an den Testanschlußflächen die Funktion der Schaltung im Normalbetrieb nicht beeinflußt. Das stromleitende Element kann beispielsweise durch einen Transistor gebildet sein, der den entsprechenden Anschluß relativ niederohmig mit dem vorgegebenen Potential verbindet. Wenn keine Umschaltung zwischen Testbetrieb und Normalbetrieb in der Schaltung vorgesehen ist, sind diese Transistoren zwar beim Testen der Schaltungen auf der Halbleiterscheibe ebenfalls stromleitend, jedoch können dann die Testsignale noch niederohmiger eingespeist werden, so daß die Verbindung mit dem vorgegebenen Potential beim Testen nicht weiter störend ist.

Ausführungsbeispiele der Erfindung werden nachstehend anhand der Zeichnung näher erläutert. Darin zeigen
- Fig. 1: einen Ausschnitt aus einer Halbleiterscheibe mit mehreren integrierten Schaltungen darauf,
- Fig. 2: ein Beispiel für eine Beschaltung eines Testeingangs.

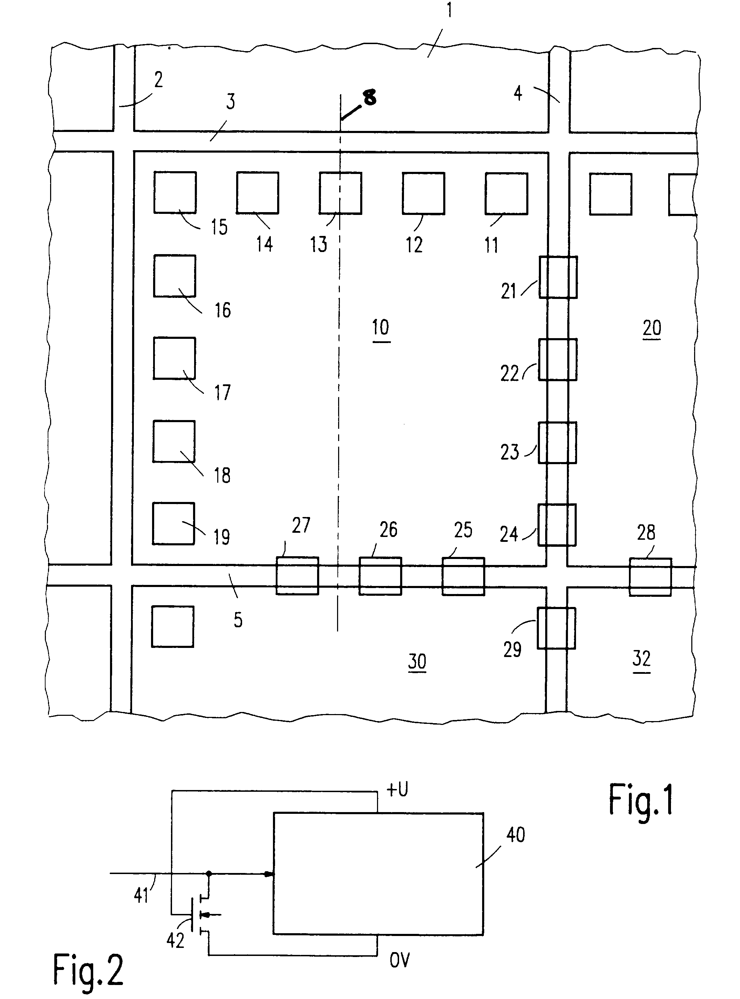

Auf dem Ausschnitt 1 einer Halbleiterscheibe in Fig. 1 befindet sich eine integrierte Schaltung 10 sowie Teile benachbarter Schaltungen 20, 30 und 32, die gemeinsame Anschlußflächen haben. Die Teile der übrigen Schaltungen haben keine Verbindung mit diesen integrierten Schaltungen 10, 20, 30 und 32 und sind daher nicht näher bezeichnet. Zwischen den einzelnen Schaltungen sind Streifen 2, 3, 4 und 5 dargestellt, die die Bahnen darstellen, auf denen nach Herstellung und Test der Schaltungen die Schnitte zum Trennen der Schaltungen geführt werden.

Die Schaltung 10 weist eine Anzahl Anschlußflächen 11 bis 19 auf, über die im normalen Betrieb Signale zugeführt oder abgenommen und ggf. Versorgungsspannungen zugeführt werden. Ferner sind eine Anzahl für das Testen verwendeter Anschlußflächen 21 bis 24, die den beiden Schaltungen 10 und 20 gemeinsam sind, sowie 25 bis 27 vorhanden, die den beiden Schaltungen 10 und 30 gemeinsam sind. Außerdem sind eine Anschlußfläche 28, die den beiden Schaltungen 20 und 32 gemeinsam ist, und eine Anschlußfläche 29 dargestellt, die den beiden Schaltungen 30 und 32 gemeinsam ist. Bei den Schaltungen 20 und 30 sind Anschlußflächen für den normalen Betrieb angedeutet, die den Anschlußflächen 11 bis 19 entsprechen. Die übrigen Anschlußflächen liegen außerhalb des Ausschnitts 1. Die eigentlichen integrierten Schaltungen, die mit den Anschlußflächen verbunden sind, sind hier der Übersichtlichkeit halber nicht näher dargestellt. Die integrierten Schaltungen 10, 20, 30 und 32 bilden durch die gemeinsamen Anschlußflächen ein zusammenhängendes "Quartett". Die Anordnung dieses im Ausschnitt 1 angedeuteten Quartetts wiederholt sich auf der gesamten Halbleiterscheibe in allen Richtungen.

Es sei bemerkt, daß bei bestimmten Schaltungen, die nur wenige äußere Anschlüsse benötigen, diese an nur einer Seite angeordnet sein können, d.h. daß in Fig. 1 nur die Anschlußflächen 11 bis 15 vorhanden sind. In entsprechender Weise können auch bei wenigen benötigten Testanschlußflächen diese an nur einer Seite angeordnet sein, d.h. bei dem in Fig. 1 dargestellten Beispiel können nur die Anschlußflächen 21 bis 24 vorhanden sein. In diesem Fall hätten nur die Schaltungen 10 und 20 gemeinsame Anschlußflächen 21 bis 24 und bilden somit ein Paar, während die Schaltungen 30 und 32 dann davon unabhängig wären und für sich ein Paar bilden würden.

Bei dem Entwurf einer integrierten Schaltung ist, nachdem die elektrische Schaltung festliegt, die Verteilung der einzelnen Elemente der Schaltung und der Verbindungen auf der Halbleiterscheibe, d.h. also das Lay-out oft sehr aufwendig. Bei der in Fig. 1 gezeigten Anordnung der Schaltungen auf der Halbleiterscheibe ist jedoch unmittelbar zu erkennen, daß diese nicht genau gleich aufgebaut sein können, da beispielsweise bezüglich der Anschlußflächen 11 bis 15 die Testanschlußfläche 21 bei der Schaltung 10 auf der rechten Seite und bei der Schaltung 20 auf der linken Seite liegt. Um für diese beiden Schaltungen daher keine getrennten Lay-outs entwerfen zu müssen, können diese für die beiden Schaltungen 10 und 20 spiegelbildlich zueinander mit der Spiegelachse in dem Streifen 4 sein. Entsprechend können auch die beiden Schaltungen 10 und 30 in ihrem Lay-out spiegelbildlich zueinander mit der Spiegelachse in dem Streifen 5 sein, d.h. die Schaltung 30 hat das gleiche Lay-out wie die Schaltung 20.

In diesem Falle ist die Zuordnung der Anschlußflächen 11 bis 19 zu ihrer Funktion bzw. der Funktion der darüber geleiteten Signale ebenfalls spiegelbildlich. Die Verbindung der Anschlußflächen zu der äußeren Umgebung wie z.B. Gehäuseanschlüssen müßte daher bei benachbarten Schaltungen unterschiedlich hergestellt werden, d.h. bei jeder Schaltung muß nach dem Trennen bei der Weiterverarbeitung festgestellt werden, zu welcher der beiden Kategorien sie gehört. Wenn bei dem in Fig. 1 dargestellten Beispiel nur, wie vorher erwähnt, die Anschlußflächen 11 bis 15 vorhanden sind, werden für zumindest einen Teil der Signale die Anschlußflächen doppelt vorgesehen, indem die Zuordnung der Anschlußflächen zu den Signalen an der Achse 8 durch die Mitte der Schaltung und hier auch durch die Mitte der Anschlußfläche 13 gespiegelt wird. Damit ist also die Anschlußfläche 11 mit der Anschlußfläche 15 verbunden, beispielsweise auch über die integrierte Schaltung selbst, und entsprechend ist die Anschlußfläche 12 mit der Anschlußfläche 14 verbunden. Wenn dann bei jeder der voneinander getrennten Schaltungen nur die mittlere Anschlußfläche 13 und die rechts davon liegenden Anschlußflächen, d.h. bei der Schaltung die Anschlußflächen 12 und 11, angeschlossen werden, empfängt jede Schaltung trotz spiegelbildlichem Aufbau stets die richtigen Signale bzw. gibt die richtigen Signale ab.

Wenn alle in Fig. 1 dargestellten Anschlußflächen 11 bis 19 vorhanden sind, könnte deren Zuordnung zu den Signalen um eine Diagonale gespiegelt sein, die durch die Anschlußfläche 15 verläuft, d.h. die Anschlußfläche 11 ist mit der Anschlußfläche 19 verbunden, 12 ist mit 18 verbunden usw..

Die Anschlußflächen einer integrierten Schaltung bestehen üblicherweise aus einer Aluminiumschicht. Wenn Schnitte beispielsweise einer Diamantsäge längs den Bahnen 4 bzw. 5 geführt werden, können Teile der Anschlußflächen 21 bis 27 verschmieren, d.h. leitende Brücken zwischen benachbarten Anschlußflächen bilden, da die Aluminiumschicht relativ weich ist. Dadurch wären dann bei der betreffenden integrierten Schaltung im normalen Betrieb diese Brücken zwischen den Testanschlüssen vorhanden, die ja weiterhin mit der betreffenden integrierten Schaltung verbunden sind. Um Fehlfunktionen durch diese Brücken im normalen Betrieb auszuschließen, wird die elektrische Schaltung so entworfen, daß alle Testeingänge bei einem bestimmten Potential, beispielsweise bei Nullpotential, die Funktion der Schaltung nicht beeinflussen, und jeder Testeingang wird über ein stromleitendes Element, beispielsweise einen Widerstand oder auch einen Transistor, relativ niederohmig an Masse gelegt.

Dies ist in Fig. 2 dargestellt. Die elektrische Schaltung, die hier vereinfacht als Block 40 dargestellt ist, empfängt über eine Leitung 41 über eine Testanschlußfläche ein Testsignal. Diese Leitung 41 ist über einen selbstsperrenden Feldeffekt-Transistor 42 mit OV verbunden, wenn die Betriebsspannung +U vorhanden ist. Ein von einer Testeinrichtung zugeführtes Signal muß also so niederohmig erzeugt bzw. zugeführt werden, daß es den durch den Transistor 42 fließenden Strom übersteigt. Dies gilt für jeden weiteren, nicht dargestellten Testeingang. Wenn im normalen Betrieb kein Testsignal über den Eingang 41 zugeführt wird, liegt dieser also auf 0V. Aus der Schaltung 40 herausgeführte Testsignale werden über eine hochohmige Pufferstufe herausgeführt, so daß, wenn eine Brücke zwischen einem Testausgang und einem Testeingang vorhanden ist, der Transistor 42 in jedem Falle diesen Testeingang auf 0V bringen kann. Damit ist also im normalen Betrieb eine Beeinflussung durch miteinander verbundene Testanschlüsse nicht möglich.

## Patentansprüche

1. Verfahren zur Herstellung von integrierten Schaltungen, bei dem eine Anzahl gleichartiger Schaltungen (10,20,30,32) auf einer Halbleiterscheibe (1) gemeinsam erzeugt und danach durch Schnitte voneinander getrennt wird, wobei jede Schaltung am Rand mit mehreren Anschlußflächen (11-27) versehen wird, von denen einige (21-27) ausschließlich für das Testen der Schaltung vor dem Trennen von den benachbarten Schaltungen verwendet werden, wobei zwischen jeweils mindestens zwei benachbarten Schaltungen (10,20) an den einander zugewandten Seiten nur für das Testen verwendete Anschlußflächen (21-24) vorgesehen werden,
dadurch gekennzeichnet, daß diese nur für das Testen verwendeten Anschlußflächen (21-24) zumindest zum Teil diesen benachbarten Schaltungen gemeinsam sind und mit ihnen verbunden sind, und daß der Schnitt zum Trennen der einzelnen Schaltungen im wesentlichen längs einer Trennlinie (4) durch diese Anschlußflächen gelegt wird.

2. Halbleiterscheibe (1) mit einer Anzahl gleichartiger Schaltungen (10,20,30,32), wobei jede Schaltung am Rand mit mehreren Anschlußflächen (11-27) versehen ist, von denen einige (21-27) ausschließlich für das Testen der Schaltung (10) vor dem Trennen von den benachbarten Schaltungen dienen und an mindestens einer Seite der Schaltung angeordnet sind,
dadurch gekennzeichnete, daß die nur für das Testen dienenden Anschlußflächen (21-24; 25-27) mit einer anderen an dieser Seite benachbarten Schaltung (20;30) gemeinsam und mit dieser ebenfalls verbunden sind, und auf einer Trennlinie (4;5) angeordnet sind.

3. Halbleiterscheibe nach Anspruch 2,
dadurch gekennzeichnet, daß benachbarte Schaltungen bezüglich der Seite, an der die gemeinsamen Anschlußflächen angeordnet sind, spiegelbildlich zueinander aufgebaut sind.

4. Halbleiterscheibe nach Anspruch 3,
dadurch gekennzeichnet, daß die für den normalen Betrieb der Schaltung vorgesehenen Anschlußflächen (11-15) an einer Seite, die senkrecht zur Seite mit den gemeinsamen Anschlußflächen steht, symmetrisch zur Seitenmitte angeordnet sind, wobei zueinander symmetrische Anschlußflächen miteinander elektrisch verbunden sind.

5. Halbleiterscheibe nach einem der Ansprüche 2 bis 4,
dadurch gekennzeichnet, daß zumindest die Anschlußflächen, die Eingänge darstellen, innerhalb der Schaltung bei angelegter Betriebsspannung über je ein stromleitendes Element mit einem vorgegebenen Potential, insbesondere einem Pol der Betriebsspannung, verbunden sind.

## Claims

1. A method of manufacturing integrated circuits by which a number of similar circuits (10, 20, 30, 32) jointly on a semiconductor slice (1) then separated from one another by cutting, each circuit being provided at the edge with several connection pads (11-27), some of which (21-27) are used exclusively for testing the circuit before it is separated from the adjoining circuits, connection pads used exclusively for testing being provided between at least two adjoining circuits each time at the sides facing one another, characterized in that said pads (21-24) used exclusively for testing are at least partly shared by said adjoining circuits and connected to them, and in that the cut for separating the individual circuits is made substantially along a separation line (4) through these connection pads.

2. Semiconductor slice (1) with a number of similar circuits (10, 20, 30, 32) each circuit being provided at the edge with several connection pads (11-27), some of which (21-27) are used exclusively for testing the circuit (10) before it is separated from the adjoining circuits, and are arranged at at least one side of the circuit, characterized in that the connection pads (21-24; 25-27) used exclusively for testing are shared with another circuit (20;30) adjoining this are also connected to this other circuit, and are arranged on a separation line (4; 5).

3. A semiconductor slice as claimed in Claim 2, characterized in that adjoining circuits have arrangements which are one another's mirrored images at the sides at at which the shared connection pads are arranged.

4. A semiconductor slice as claimed in Claim 3, characterized in that the connection pads (11-15) provided for the normal operation of the circuit are provided at a side which is perpendicular to the side with the shared connection pads symmetrically relative to the centre of the former side, mutually symmetrical connection pads being electrically interconnected each time.

5. A semiconductor as claimed in any one of the Claims 2 to 4, characterized in that at least those connection pads represent inputs are each connected to a given potential, particularly a pole of the operating voltage, via a conducting element within the circuit while the operating voltage is applied.

## Revendications

1. Procédé de fabrication de circuits intégrés, dans lequel un nombre de circuits similaires (10, 20, 30, 32) est produit ensemble sur une plaque semi-conductrice (1), lesquelles sont ensuite séparées mutuellement par découpe, chaque circuit étant pourvu de plusieurs surfaces de raccordement (11-27) au bord, dont certaines (21-27) sont utilisées exclusivement pour tester le circuit avant la séparation des circuits adjacents, des surfaces de raccordement (21-24) utilisées uniquement pour tester étant prévues entre au moins deux circuits adjacents (10, 20) respectifs, aux côtés se faisant mutuellement face, caractérisé en ce que ces surfaces de raccordement (21-24) uniquement utilisées pour tester sont communes au moins en partie à ces circuits adjacents et connectées à ceux-ci, et en ce que la découpe de séparation des différents circuits est placée principalement le long d'une ligne de séparation (4) à travers ces surfaces de raccordement.

2. Plaque semi-conductrice (1) comprenant un nombre de circuits analogues (10, 20, 30, 32), chaque circuit étant pourvu de plusieurs surfaces de raccordement (11-27) au bord, dont certaines (21-27) servent uniquement à tester le circuit (10) avant la séparation des circuits adjacents et qui sont agencées sur au moins un côté du circuit, caractérisée en ce que les surfaces de raccordement (21-24; 25-27) servant uniquement à tester sont communes à un autre circuit (20; 30) adjacent à ce côté, et en ce qu'elles sont également connectées à celui-ci, et agencées sur une ligne de séparation (4; 5).

3. Plaque semi-conductrice suivant la revendication 2, caractérisée en ce que des circuits adjacents sont agencés mutuellement en image symétrique par rapport au côté sur lequel les surfaces de raccordement communes sont agencées.

4. Plaque semi-conductrice suivant la revendication 3, caractérisée en ce que les surfaces de raccordement (11-15) prévues pour le service normal du circuit sont agencées à un côté, qui est perpendiculaire au côté comprenant les surfaces de raccordement communes, symétriquement par rapport au milieu du côté, des surfaces de raccordement mutuellement symétriques étant mutuellement connectées électriquement.

5. Plaque semi-conductrice suivant l'une des revendications 2 à 4, caractérisée en ce qu'au moins les surfaces de raccordement, qui présentent des entrées, sont connectées à l'intérieur du circuit sous application d'une tension de service par un élément conducteur de courant à la fois possédant un potentiel prédéterminé, en particulier un pôle de la tension de service.
